Europäisches Patentamt

European Patent Office

Office européen des brevets

(19)

(11) Veröffentlichungsnummer: **0 120 417**
A1

(12)                 EUROPÄISCHE PATENTANMELDUNG

(21) Anmeldenummer: 84102870.7

(22) Anmeldetag: 15.03.84

(51) Int. Cl.³: **H 03 K 17/08**
H 02 M 3/335

(30) Priorität: 18.03.83 DE 3309871

(43) Veröffentlichungstag der Anmeldung:
03.10.84 Patentblatt 84/40

(84) Benannte Vertragsstaaten:
AT BE DE FR GB IT NL

(71) Anmelder: Siemens Aktiengesellschaft
Berlin und München Wittelsbacherplatz 2
D-8000 München 2(DE)

(72) Erfinder: Schott, Heinrich, Dipl.-Ing.
Seebergerstrasse 6 a
D-8000 München 71(DE)

(54) Schaltungsanordnung zur Verringerung der Schaltverluste eines elektronischen Schalters in Gleichstromumrichtern.

(57) Zur Verringerung der Schaltverluste eines zwischen einem ersten Pol (E1) einer Eingangsspannungsquelle und einem Verbraucher (R) angeordneten elektronischen Schalters (T1) in Gleichstromumrichtern ist vorgesehen, diesem eine aus einem Kondensator (C2) und einer beim Öffnen des Schalters das Aufladen des Kondensators bewirkenden ersten Diode (D1) bestehende Reihenschaltung parallel zu schalten. Der Verbindungspunkt zwischen dem Kondensator (C2) und der ersten Diode (D1) ist dabei lediglich über eine beim Schließen des Schalters (T1) das Entladen des Kondensators (C2) bewirkende zweite Diode (D2) mit dem zweiten Pol (E2) der Eingangsspannungsquelle verbunden.

EP 0 120 417 A1

0120417

SIEMENS AKTIENGESELLSCHAFT   Unser Zeichen
Berlin München   VPA   83 P 1164 E

Schaltungsanordnung zur Verringerung der Schaltverluste
eines elektronischen Schalters in Gleichstromumrichtern

Die Erfindung betrifft eine Schaltungsanordnung zur Verringerung der Schaltverluste eines zwischen einem ersten Pol
einer Eingangsspannungsquelle und einem Verbraucher angeordneten elektronischen Schalters in Gleichstromumrichtern,
insbesondere in Durchflußumrichtern, welchem eine Reihenschaltung, bestehend aus einem Kondensator und einer beim
Öffnen des Schalters das Aufladen des Kondensators bewirkenden ersten Diode, parallelgeschaltet ist, wobei der Verbindungspunkt zwischen dem Kondensator und der Diode über
eine gesonderte Diodenanordnung mit dem anderen Pol der
Eingangsspannungsquelle verbunden ist.

Es ist bereits eine Schaltungsanordnung zur Verringerung
der Ausschaltverluste des Halbleiterschalters in Schaltreglern bekannt (DE-AS 27 18 996). Bei dieser bekannten
Schaltungsanordnung ist dem zwischen einem ersten Pol einer
Eingangsspannungsquelle und einem Verbraucher angeordneten
Halbleiterschalter ein Kondensator und eine in Durchlaßrichtung gepolte Diode parallelgeschaltet. Der Verbindungspunkt zwischen dem Kondensator und der Diode ist dabei über
eine Drosselspule und zwei in Reihe geschaltete Dioden mit
dem zweiten Pol der Eingangsspannungsquelle verbunden. An
den Verbindungspunkt dieser beiden Dioden ist ein zusätzlilicher Kondensator angeschlossen, der mit seinem anderen
Anschluß über den Halbleiterschalter mit dem ersten Pol der
Eingangsspannungsquelle verbunden ist.

Eine Verringerung der Ausschaltverluste des Halbleiterschal-

28.02.1983 / Kzr 1 Gru

ters wird bei der bekannten Schaltungsanordnung dadurch erreicht, daß zum Zeitpunkt des Öffnens des Halbleiterschalters der zusätzliche Kondensator auf die Eingangsspannung aufgeladen ist, während der dem Halbleiterschalter parallelgeschaltete Kondensator keine Ladung aufweist. Von diesem Zeitpunkt an entlädt der durch den Verbraucher fliessende Laststrom den zusätzlichen Kondensator. Gleichzeitig wird der dem Halbleiterschalter parallelgeschaltete Kondensator auf die Eingangsspannung aufgeladen. Beim darauffolgenden Schließen des Halbleiterschalters wird ein aus den beiden Kondensatoren und der Drosselspule bestehender Umladestromkreis geschlossen. Aufgrund des Schwingkreisverhaltens dieses Stromkreises wird die Energie des dem Halbleiterschalter parallelgeschalteten Kondensators auf den zusätzlichen Kondensator umgeladen, so daß vor dem erneuten Öffnen des Halbleiterschalters der dem Halbleiterschalter parallelgeschaltete Kondensator spannungslos und der zusätzliche Kondensator wieder auf die Eingangsspannung aufgeladen ist.

Mit Hilfe der gerade erläuterten Zusatzschaltung werden zwar die Ausschaltverluste des Halbleiterschalters verringert. Hierfür ist jedoch ein schaltungstechnischer Aufwand erforderlich, der zuweilen unerwünscht ist.

Der Erfindung liegt nun die Aufgabe zugrunde, einen Weg zu zeigen, wie bei einer Schaltungsanordnung der eingangs betrachteten Art die in dem elektronischen Schalter auftretenden Schaltverluste durch eine geringere, selbst nur niedrige Eigenverluste aufweisende Beschaltung vermindert werden können.

Gelöst wird die vorstehend aufgezeigte Aufgabe bei einer Schaltungsanordnung der eingangs genannten Art erfindungsgemäß dadurch, daß der Verbindungspunkt zwischen dem Kondensator und der ersten Diode mit dem zweiten Pol der Eingangsspannungsquelle über lediglich eine beim Schließen des Schalters das Entladen des Kondensators bewirkende zweite Diode verbunden ist.

Die Erfindung bringt den Vorteil mit sich, daß mit einem geringen schaltungstechnischen Aufwand die Schaltverluste eines elektronischen Schalters in Gleichstromumrichtern verringert werden können. Dabei arbeiten die Gleichstromumrichter auch bei höheren Arbeitsfrequenzen mit einem guten Wirkungsgrad, da lediglich an den beiden Dioden geringe Durchlaßverluste auftreten. Außerdem wird der Kondensator bei Schaltvorgängen wechselspannungsmäßig wesentlich geringer belastet als die beim Stand der Technik vorgesehenen Kondensatoren. Dies ermöglicht die Verwendung eines kostengünstigen Kondensatortyps. Die geringere Wechselspannungsbelastung des Kondensators gemäß der vorliegenden Erfindung ist dadurch bedingt, daß an diesem bei Schaltvorgängen lediglich Spannungsdifferenzen auftreten, die wesentlich niedriger sind als die von der Eingangsspannungsquelle bereitgestellte Eingangsspannung. Demgegenüber erfolgt beim Stand der Technik eine vollständige Entladung der Kondensatoren, so daß an diesen Spannungen auftreten, die mindestens so groß wie die zugeführte Eingangsspannung sind.

Bei der Verwendung der Schaltungsanordnung gemäß der vorliegenden Erfindung in Durchflußumrichtern mit hohen Ausgangsströmen ist es vorteilhaft, daß zwischen die zweite Diode und den zweiten Pol der Eingangsspannungsquelle eine Drosselspule zur Verzögerung der Entladung des Kondensators geschaltet ist. Damit wird die Entladung des Kondensators so weit verzögert, daß ein durch den Sperrverzug der in Durchflußumrichtern vorhandenen Freilaufdiode bedingter Einschaltverlust des elektronischen Schalters vermieden wird.

Anhand einer Zeichnung wird die Erfindung nachstehend beispielsweise näher erläutert.

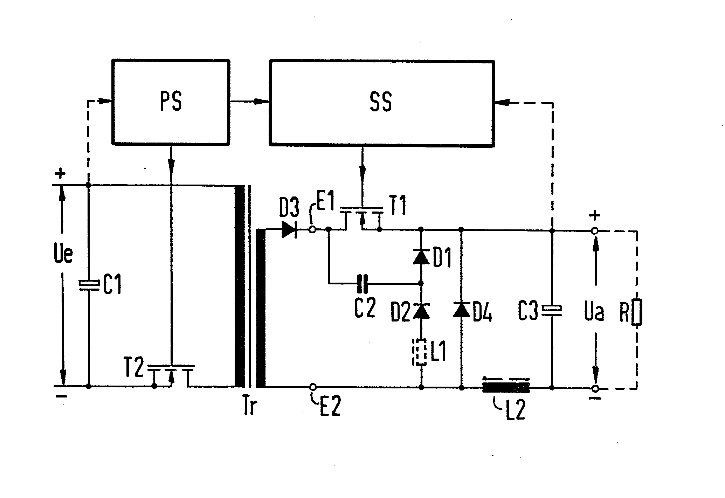

Die Zeichnung zeigt in vereinfachter Form einen Eintakt-
Durchflußumrichter mit Netztrennung. Diesem Durchflußumrichter wird primärseitig an seinen Eingängen eine Gleichspannung Ue zugeführt. Mit diesen Eingängen ist ein Kondensator C1 verbunden, dem eine Reihenschaltung, bestehend aus der Primärwicklung eines Transformators Tr und
einem Transistor T2, parallelgeschaltet ist. Bei dem hier
betrachteten Ausführungsbeispiel handelt es sich bei dem
Transistor um einen MOS-Leistungstransistor, der mit seinem Drain-Anschluß mit der Primärwicklung des Transformators Tr und mit seinem Source-Anschluß mit einem der Eingänge (Minuspol der Gleichspannung Ue) verbunden ist. Zur
Steuerung dieses Transistors T2 ist dieser mit seinem Gate-
Anschluß an eine Primärsteueranordnung PS angeschlossen.Diese Primärsteueranordnung gibt periodisch Impulssignale ab,
durch deren Auftreten der Transistor T2 von seinem gesperrten Zustand in den leitfähigen Zustand gesteuert wird.
Die Folgefrequenz dieser Impulssignale liegt dabei im allgemeinen oberhalb der Hörfrequenzen, beispielsweise bei
einer Frequenz von 60 kHz.

Soll die gerade erwähnte Primärsteueranordnung PS mit in
die Regelung der von dem Durchflußumrichter abzugebenden
Ausgangsspannung einbezogen werden, so kann beispielsweise bei konstanter Folgefrequenz der Impulssignale der
Tastgrad dieser Impulssignale, d.h.das Verhältnis von Impulsdauer zu Impulspause, variiert werden. Zur Festlegung
des jeweils in Frage kommenden Tastgrades kann die dem
Durchflußumrichter zugeführte Gleichspannung Ue herangezogen werden. Auf die Wirkungsweise der Primärsteueranordnung wird im folgenden nicht näher eingegangen. Es sei
hier lediglich angemerkt, daß die von der Primärsteueranordnung abgegebenen Impulssignale auch zur Steuerung der Sekundärseite und zur sekundärseitigen Regelung der von dem
Durchflußumrichter abzugebenden Ausgangsspannung ausgenutzt
werden.

Mit einem Anschluß der Sekundärwicklung des Transformators
Tr ist eine Diode D3 mit ihrer Anode verbunden. Die Kathode
dieser Diode (Verbindungspunkt E1) steht einerseits mit dem
Drain-Anschluß eines MOS-Leistungstransistors T1 und andererseits mit einem Kondensator C2 in Verbindung. Der Source-
Anschluß dieses Leistungstransistors ist mit einem der Ausgänge des Durchflußumrichters verbunden (Pluspol). Gesteuert wird dieser Leistungstransistor von einer Sekundärsteueranordnung SS, von der dieser an seinem Gate-Anschluß Impulssignale zugeführt erhält. Diese Impulssignale werden
aus den Impulssignalen abgeleitet, die für die Steuerung
des auf der Primärseite vorhandenen Leistungstransistors T2
von der Primärsteueranordnung PS abgegeben werden. Der Leistungstransistor T1 wird durch die ihm zugeführten Impulssignale wie der Leistungstransistor T2 von seinem Sperrzustand in seinen leitfähigen Zustand gesteuert.

Die gerade erwähnte Sekundärsteueranordnung SS dient im
wesentlichen für die Regelung der von dem Durchflußumrichter abzugebenden Ausgangsspannung. Hierzu wird dieser
als Regelgröße die Ausgangsspannung zugeführt, wie dies
in der Zeichnung durch die unterbrochene Verbindungslinie zu der Sekundärsteueranordnung hin angedeutet ist.
Die Regelung erfolgt dabei in der Weise, daß der Tastgrad der von der Primärsteueranordnung PS zur Verfügung
gestellten Impulssignale verkleinert wird.

Die Sekundärsteueranordnung SS kann neben Einrichtungen
für die Regelung der von dem Durchflußumrichter abzugebenden Ausgangsspannung auch zusätzliche Steuereinrichtungen,
wie z.B. für die Begrenzung des von dem Durchflußumrichter abzugebenden Stromes, aufweisen. Auf den Aufbau derartiger Steuereinrichtungen wird jedoch hier nicht näher eingegangen.

Mit dem Source-Anschluß des bereits genannten MOS-Leistungstransistors T1 ist die Kathode einer Diode D1 verbunden. Diese Diode ist Bestandteil einer Reihenschaltung, die neben dieser Diode eine in der gleichen Richtung gepolte weitere Diode D2 und gegebenenfalls eine Drosselspule L1 aufweist. Diese Reihenschaltung ist mit ihrem anderen Ende, d.h. mit der Drosselspule L1 oder, falls diese nicht vorhanden ist, mit der Diode D2, mit dem anderen Ende der Sekundärwicklung des Transformators Tr verbunden. (Verbindungspunkt E2). Auf die Wirkungsweise dieser Drosselspule wird im folgenden noch näher eingegangen. Der Verbindungspunkt zwischen den beiden Dioden D1 und D2 ist mit dem bereits erwähnten Kondensator C2 verbunden.

Parallel zu der gerade erwähnten Reihenschaltung ist eine weitere Diode D4 geschaltet, die in dem Durchflußumrichter als Freilaufdiode wirkt.

Mit dem als Verbindungspunkt E2 bezeichneten Anschluß der Sekundärwicklung des Transformators Tr ist außerdem eine weitere Drosselspule L2 verbunden, die mit ihrem anderen Anschluß mit einem weiteren Ausgang des Durchflußumrichters verbunden ist (Minuspol der Ausgangsspannung Ua). Den Ausgängen des Durchflußumrichters, an die ein in Frage kommender Verbraucher R anzuschließen ist, ist schließlich noch ein Kondensator C3 parallelgeschaltet.

In der Zeichnung sind für eine vereinfachte Darstellung eines Eintakt-Durchflußumrichters lediglich die für die Bereitstellung einer einzigen Ausgangsspannung Ua vorgesehenen Schaltungselemente angegeben. Im allgemeinen wird mit einem solchen Durchflußumrichter jedoch eine Mehrzahl von unterschiedlichen Ausgangsspannungen gleichzeitig bereitgestellt. In diesem Fall sind dann die zuvor erwähnten, auf der Sekundärseite des Durchflußumrichters vorhandenen Schaltungselemente in einer der Mehrzahl der Ausgangsspannungen entsprechenden Anzahl vorhanden.

Nachdem zuvor der Aufbau des in der Zeichnung dargestellten Eintakt-Durchflußumrichters erläutert worden ist, wird nun noch auf die Wirkungsweise der zur Verringerung der Schaltverluste in dem Leistungstransistor T1 dienenden Schaltungsanordnung näher eingegangen. Hierzu wird zunächst davon ausgegangen, daß die beiden Leistungstransistoren T1 und T2 in den leitfähigen Zustand gesteuert werden. Dies erfolgt, wie bereits oben erwähnt, durch ein an den Gate-Anschlüssen dieser Leistungstransistoren auftretendes Impulssignal. Die Überführung in diesen Zustand erfolgt nahezu gleichzeitig. Geringe zeitliche Differenzen treten lediglich durch interne Laufzeiten innerhalb der Sekundärsteueranordnung SS auf. Die Dauer des leitfähigen Zustands dieser Leistungstransistoren wird durch die Tastgrade der jeweils zugeführten Impulssignale bestimmt. Wie bereits oben erwähnt, können dabei die Tastgrade der auf der Primärseite und auf der Sekundärseite für die Steuerung verwendeten Impulssignale voneinander abweichen.

Wird nun der Leistungstransistor T1 in den Sperrzustand überführt, so wird der Kondensator C2 durch einen über die in Durchlaßrichtung gepolten Dioden D3 und D1 und den Verbraucher R fließenden Ladestrom aufgeladen. Es stellt sich an diesem Kondensator eine Spannung ein, die von seiner Kapazität und von der vorhandenen Energie in der Steuerinduktivität des Transformators Tr und der Leitungen abhängt. Die Spannung an dem Kondensator C2 steigt dabei abhängig von der gewählten Dimensionierung mehr oder weniger über die vorher von der Sekundärwicklung

0120417

des Transformators Tr gelieferte Impulsspannung an. Im Sperrzustand des Leistungstransistors T1 verhindert dann die Diode D3 ein erneutes Entladen des Kondensators C2. Beim Übergang des Leistungstransistors T1 in den Sperrzustand fließt im übrigen noch ein Strom über die Freilaufdiode D4 und den Verbraucher R. Dieser Strom wird hervorgerufen durch die im leitfähigen Zustand des Leistungstransistors T1 und damit bei einem über den Verbraucher R geschlossenen Stromkreis von der Drosselspule L2 aufgenommene Energie.

Wird nun der Leistungstransistor T1 erneut in den leitfähigen Zustand gesteuert, so wird der Kondensator C2 über die Diode D2 parallel zur Sekundärwicklung des Transformators Tr wirksam und entlädt sich bis auf die von der Sekundärwicklung des Transformators abgegebene Impulsspannung. Die dabei dem Kondensator C2 entnommene Energie wird dabei durch einen kurzzeitig fließenden Entladestrom dem Verbraucher R zugeführt. Dieser Entladestrom, dessen Höhe von der Drosselspule L2 und dem Durchlaßwiderstand der Diode D2 abhängig ist, ist dem im leitfähigen Zustand des Leistungstransistors T1 zu dem Verbraucher R hin fließenden Strom überlagert.

Durch die gerade erläuterten Lade- bzw. Entladevorgänge in dem Kondensator C2 beim Übergang des Leistungstransistors von dem leitfähigen Zustand in den Sperrzustannd bzw. vom Sperrzustand in den leitfähigen Zustand werden durch Induktivitäten hervorgerufene Überspannungsspitzen vermieden. Da sowohl das Aufladen als auch das Entladen des Kondensators C2 über Diodenstrecken mit einem geringen Durchlaßwiderstand erfolgt, wird ein guter Wirkungsgrad des Durchflußumrichters erreicht.

Wie bereits oben erwähnt, kann in Reihe zu der Diode D2 eine weitere Drosselspule L1 geschaltet werden. Diese Maßnahme ist insbesondere dann vorteilhaft, wenn der hier betrachtete Durchflußumrichter für hohe Ausgangsströme auszulegen ist. Die Drosselspule L1, die beispielsweise eine UKW-Drossel sein kann, verzögert geringfügig die Entladung des Kondensators C2. Damit wird verhindert, daß beim Übergang des Leistungstransistors T1 in den leitfähigen Zustand innerhalb der Sperrverzugszeit der Freilaufdiode D4 ein in dem Leistungstransistor T1 Verluste hervorrufender Kurzschluß- Entladestrom über die Freilaufdiode D4 fliessen kann. Die gerade erwähnte Sperrverzugszeit ist abhängig von dem durch die Diode fließenden Strom.

Vorstehend wurde die Wirkungsweise der Schaltungsanordnung gemäß der vorliegenden Erfindung am Beispiel eines Eintakt-Durchflußumrichters mit Netztrennung beschrieben, bei dem dem Leistungstransistor T1 durch den Transformator Tr eine Impulsspannung zugeführt wird. Die erfindungsgemäße Schaltungsanordnung ist jedoch nicht nur für derartige Durchflußumrichter geeignet. Vielmehr ist diese Schaltungsanordnung auch vorteilhaft in Gleichstromumrichtern einsetzbar, deren Leistungstransistoren Gleichspannungen zugeführt erhalten. Bei solchen Gleichstromumrichtern kann es sich beispielsweise um Durchflußumrichter ohne galvanische Trennung oder um Sperrumrichter handeln.

2 Patentansprüche
1 Zeichnung

0120417

Patentansprüche

1. Schaltungsanordnung zur Verringerung der Schaltverluste eines zwischen einem ersten Pol (E1) einer Eingangsspannungsquelle und einem Verbraucher (R) angeordneten elektronischen Schalters (T1) in Gleichstromumrichtern, insbesondere in Durchflußumrichtern, welchem eine Reihenschaltung, bestehend aus einem Kondensator (C2) und einer beim Öffnen des Schalters das Aufladen des Kondensators bewirkenden ersten Diode (D1), parallelgeschaltet ist, wobei der Verbindungspunkt zwischen dem Kondensator (C2) und der Diode (D1) über eine gesonderte Diodenanordnung (D2) mit dem anderen Pol (E2) der Eingangsspannungsquelle verbunden ist, d a d u r c h   g e k e n n z e i c h n e t , daß der Verbindungspunkt zwischen dem Kondensator (C2) und der ersten Diode (D1) mit dem zweiten Pol (E2) der Eingangsspannungsquelle über lediglich eine beim Schließen des Schalters (T1) das Entladen des Kondensators bewirkende zweite Diode (D2) verbunden ist.

2. Schaltungsanordnung nach Anspruch 1, d a d u r c h   g e k e n n z e i c h n e t , daß zwischen die zweite Diode (D2) und den zweiten Pol (E2) der Eingangsspannungsquelle eine Drosselspule (L1) zur Verzögerung der Entladung des Kondensators (C2) geschaltet ist.

## EUROPÄISCHER RECHERCHENBERICHT

Europäisches
Patentamt

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | GB-A-2 015 291 (MAWDSLEY'S LTD.) <br> * Figur 4; Zusammenfassung; Seite 1, Zeile 125 - Seite 2, Zeile 88 * <br><br> --- | 1,2 | H 03 K 17/08 <br> H 02 M 3/335 |
| X | DE-A-2 644 715 (A. BOEHRINGER) <br> * Figur 8; Seite 25, Zeile 22 - Seite 30, Zeile 26; Seite 22, Zeile 21 - Seite 24, Zeile 10 * <br><br> --- | 1 | |
| X | DE-A-2 651 492 (A. BOEHRINGER) <br> * Figur 8 * <br><br> --- | 1 | |
| D,A | DE-B-2 718 996 (SIEMENS AG) <br> * Figur 2 * <br><br> --- | 1 | |
| A | DE-A-2 641 183 (A. BOEHRINGER) <br><br> --- | | RECHERCHIERTE SACHGEBIETE (Int Cl. ³) |
| A | DE-A-2 716 367 (SIEMENS AG) <br><br> --- | | H 02 M 3/335 <br> H 03 K 17/08 |
| A | DE-B-1 176 709 (LICENTIA PATENT-VERWALTUNGS-GMBH) <br><br> --- | | |
| A | US-A-3 571 614 (A.A. ROLSTEAD) <br><br> --- -/- | | |

Der vorliegende Recherchenbericht wurde für alle Patentansprüche erstellt.

| Recherchenort <br> BERLIN | Abschlußdatum der Recherche <br> 15-05-1984 | Prüfer <br> ARENDT M |
|---|---|---|

Europäisches
Patentamt

**EUROPÄISCHER RECHERCHENBERICHT**

01204 1 7
Nummer der Anmeldung

EP    84 10 2870

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int Cl. ³) |
|---|---|---|---|
| A | ELEKTROTECHNISCHE ZEITSCHRIFT, Band 100, Nr. 13, Juni 1979 A. BOEHRINGER et al. "Transistorschalter im Bereich hoher Leistungen und Frequenzen", Seiten 664-669 | | |
| | --- | | |
| A | ELEKTRONIK, Band 30, Nr. 18, September 1981, München K. RISCHMÜLLER "Verbesserte Basisansteuerung vereinfacht transistorisierte Leistungsumrichter", Seiten 75-80 | | |
| | --- | | |
| A | DE-A-2 719 026  (SIEMENS AG) | | |
| | ----- | | RECHERCHIERTE SACHGEBIETE (Int Cl. ³) |

Der vorliegende Recherchenbericht wurde für alle Patentansprüche erstellt

| Recherchenort BERLIN | Abschlußdatum der Recherche 15-05-1984 | Prüfer ARENDT M |
|---|---|---|